# EUROPEAN PATENT APPLICATION

(11) **EP 1 806 773 A1**
(43) Date of publication of application: **11.07.2007**
(21) Application number: 05793182.6
(22) Date of filing: 12.10.2005
(51) Int. Cl.: H01L 21/027, G03F 7/20

(54) **EXPOSURE DEVICE, EXPOSURE METHOD, AND DEVICE MANUFACTURING METHOD**

(30) Priority: 13.10.2004 JP 2004298972; 10.12.2004 JP 2004358606
(71) Applicant: NIKON CORPORATION, Tokyo 100-8331 (JP)
(72) Inventor: NAGASAKA, Hiroyuki, Chiyoda-ku, Tokyo 1008331 (JP)
(74) Representative: Viering, Jentschura & Partner
(86) International application number: PCT/JP2005/018783
(87) International publication number: WO 2006/041086

(57) **Abstract**

An exposure apparatus (EX) fills an optical path space on a side of an image plane of a projection optical system (PL) with liquid (LQ) and exposes a substrate (P) via the projection optical system (PL) and the liquid (LQ). The exposure apparatus (EX) has a measurement unit (30) which measures an optical property of the liquid (LQ). According to the measurement result, it is possible to adjust the optical characteristic of the liquid by a liquid mixing unit (19). Thus, it is possible to maintain the exposure accuracy at a desired state when performing immersion exposure.

## Description

### TECHNICAL FIELD

The present invention relates to an exposure apparatus and an exposure method for exposing a substrate through a liquid, and a method for producing a device.

### BACKGROUND ART

In photolithography process which is one of the production processes for a micro device such as a semiconductor device or a liquid crystal display device, an exposure apparatus which performs projection exposure of a pattern formed on a mask onto a photosensitive substrate, is employed. This exposure apparatus has a mask stage for supporting a mask and a substrate stage for supporting a substrate, and performs projection exposure of the pattern of the mask onto the substrate via a projection optical system while successively moving the mask stage and the substrate stage. In the production of the micro device, in order to increase the density of the device, it has been demanded to decrease the size of the pattern to be formed on the substrate. To meet this demand, the higher resolution of the exposure apparatus has been desired. As one of the means for realizing this higher resolution, a liquid immersion exposure apparatus is proposed which forms a liquid immersion area by filling a liquid in a space between the projection optical system and the substrate and performs an exposure processing through the liquid in the liquid immersion area as disclosed in the following patent document 1.
Patent document 1: International Publication Pamphlet No. 99/19504.

### DISCLOSURE OF THE INVENTION

### Task to Be Solved by the Invention:

In the liquid immersion exposure apparatus, there is a possibility that an image formation characteristic and the like through the liquid varies due to a change of the property of the liquid and as a result, a desired exposure accuracy cannot be maintained.

The present invention has been made taking the foregoing circumstances into consideration, and an object of which is to provide an exposure apparatus and an exposure method in which the exposure accuracy when performing exposure through the liquid can be maintained at a desired state, and a method for producing a device based on the use of the exposure apparatus.

### Solution for the Task:

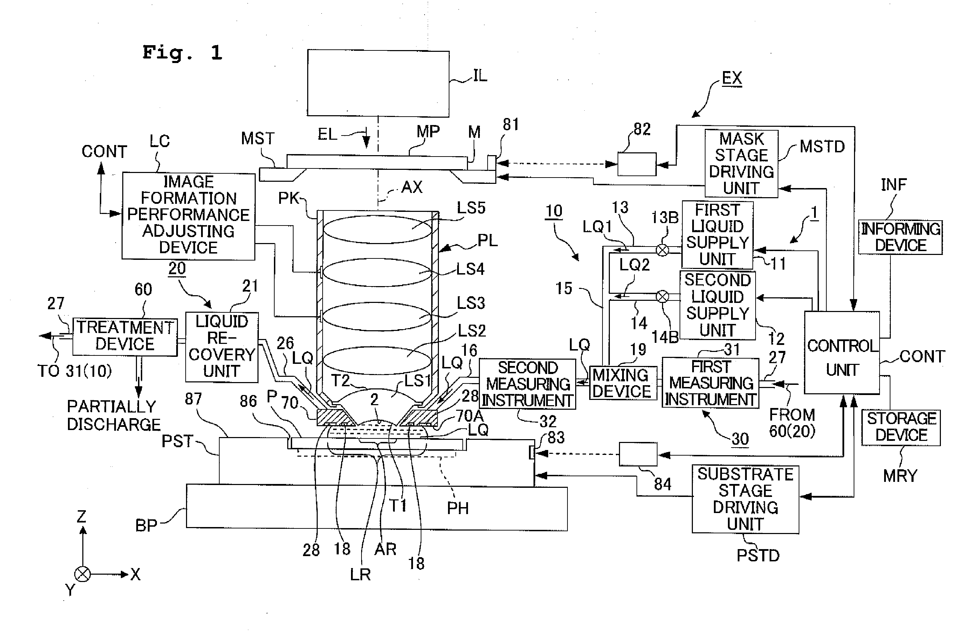

In order to overcome the task, the present invention adopts the following constructions corresponding to Figs. 1 to 10 as illustrated in the embodiments. However, parenthesized reference numerals affixed to respective elements merely exemplify the elements by way of example, with which it is not intended to limit the respective elements.

According to a first aspect of the present invention, there is provided an exposure apparatus (EX) which exposes a substrate (P) through a liquid (LQ), the exposure apparatus comprising a projection optical system (PL) and a measuring device (30) which measures optical property of the liquid (LQ).

According to the first aspect of the invention, the measuring device which measures optical property of the liquid is provided, so that it is possible to grasp the optical property of the liquid based on the result of measurement made by the measuring device and perform a proper process or action. Therefore, the exposure accuracy when performing exposure through the liquid can be maintained at a desired state.

According to a second aspect of the present invention, there is provided an exposure apparatus (EX) which exposes a substrate through a liquid, the exposure apparatus comprising a projection optical system (PL), a liquid supply mechanism (10) which supplies the liquid to a side of an image plane of the projection optical system (PL), and a mixing device (19) which is provided in the liquid supply mechanism (10) and mixes a plurality of liquids (LQ1, LQ2), wherein the liquid supply mechanism (10) supplies the liquid mixed by the mixing device.

According to the second aspect of the present invention, by properly mixing the plurality of liquids by the mixing device, the liquid with a desired property can be prepared. Therefore, it is possible to allow the exposure accuracy in a desired state when performing exposure through the liquid.

According to a third aspect of the present invention, there is provided a method for producing a device using an exposure apparatus (EX) according to the aspect described above. According to the third aspect of the present invention, a desired exposure accuracy can be maintained, so that the device with the desired performance can be produced.

According to a fourth aspect of the present invention, there is an exposure method for exposing a substrate (P) with an image of a predetermined pattern (MP) through a liquid (LQ), the exposure method comprising measuring optical property of the liquid (LQ) before supplying the liquid (LQ) to an area (AR) in which the image of the predetermined pattern (MP) is formed, adjusting an image formation characteristic of the image of the predetermined pattern (MP) and exposing the substrate (P) with the image of the predetermined pattern (MP) through the liquid (LQ).

According to the exposure method of the fourth aspect of the present invention, the optical property of the liquid is measured before supplying the liquid to the area in which the image of the predetermined pattern is formed, so that a desired image of the pattern can be formed on the substrate based on the result of the measurement.

According to a fifth aspect of the present invention, there is provided an exposure method for exposing a substrate (P) with an image of a predetermined pattern (MP) through a liquid (LQ), the exposure method comprising mixing (S3) a plurality of liquids (LQ1, LQ2), measuring optical property of the liquid (LQ) before (S2) and/or after (S4) the mixing of the plurality of liquids, and exposing the substrate (P) through the liquid which has been mixed.

According to the exposure method of the fifth aspect of the present invention, before and/or after mixing the plurality of liquids, the optical property of the liquid is measured, so that a desired liquid can be supplied onto the substrate based on the result of the measurement.

According to a sixth aspect of the present invention, there is provided an exposure method for exposing a substrate (P) with an image of a predetermined pattern (MP) through a liquid (LQ), the exposure method comprising mixing a plurality of liquids (LQ1, LQ2), adjusting an image formation characteristic of the image of the predetermined pattern (MP) so that a desired image of the predetermined pattern is obtained, and exposing the substrate (P) through the liquid (LQ1, LQ2) which has been mixed.

According to the exposure method of the sixth aspect of the present invention, by mixing a plurality of liquids to provide a desired liquid for liquid immersion exposure and adjusting the image formation characteristic so as to obtain the desired image of the predetermined pattern (MP) through the prepared liquid, conditions of liquid immersion exposure including the image formation characteristic can be optimized.

According to a seventh aspect of the present invention, there is provided a method for producing a device, the method for producing the device comprising exposing (S6, 204) a substrate by the exposure method according to any aspect described above, developing (204) the substrate which has been exposed, and processing (205) the substrate which has been developed. According to the seventh aspect of the present invention, a desired exposure accuracy can be maintained, thus the device having a desired performance can be produced.

### Effect of the Invention:

According to the present invention, the exposure accuracy when performing exposure through the liquid can be maintained in a desired range, and the device with the desired performance can be provided.

### BRIEF DESCRIPTION OF THE DRAWINGS

Fig. 1 is a schematic arrangement view illustrating an exposure apparatus according to a first embodiment;
Fig. 2 is an arrangement view illustrating a liquid supply mechanism;
Fig. 3 is an external perspective view illustrating a measuring unit;
Fig. 4 is a sectional view illustrating the measuring unit;
Fig. 5 is a flowchart illustrating an example of an exposure method;
Fig. 6 is an enlarged view of the vicinity of a first optical element;
Fig. 7 is an arrangement view illustrating a liquid supply mechanism according to a second embodiment;
Fig. 8(A) and Fig. 8(B) are drawings illustrating a measuring unit according to a third embodiment;
Fig. 9 is an enlarged view of the vicinity of a first optical element according to a fourth embodiment; and
Fig. 10 is a flowchart illustrating an example of a production process of a micro device.

### Legends of Reference Numerals:

1: liquid immersion mechanism, 10: liquid supply mechanism, 19: mixing unit, 20: liquid recovery mechanism, 30: measuring instrument, 31: first measuring instrument, 32: second measuring instrument, 42: temperature controller, 60: process unit, 70: nozzle member, CONT: control unit, EL: exposure light beam, EX: exposure apparatus, INF: informing (reporting) unit, LC: image formation characteristic adjusting unit, LQ: liquid, LQ1: first liquid, LQ2: second liquid, LS1: first optical element, MRY: storage unit, P: substrate, PL: projection optical system, PST: substrate stage, PSTD: substrate stage driving unit, T1: lower surface

### BEST MODE FOR CARRYING OUT THE INVENTION

Hereinafter, embodiments of the present invention will be described with reference to the drawings, however, the invention is not limited thereto.

### First embodiment

Fig. 1 shows a schematic arrangement view illustrating an exposure apparatus EX according to a first embodiment. In Fig. 1, the exposure apparatus EX includes a mask stage MST which is movable while holding a mask M, a substrate stage PST which is movable while holding a substrate P, an illumination optical system IL which illuminates the mask M held on the mask stage MST with an exposure light beam EL, a projection optical system PL which projects an image of a pattern MP of the mask M illuminated with the exposure light beam EL onto the substrate P held on the substrate stage PST, and a control unit CONT which integrally controls the overall operation of the exposure apparatus EX. The control unit CONT is connected to a storage unit MRY which stores various information on the exposure process. Also, the control unit CONT is connected to a reporting unit INF which reports information on the exposure process.

The exposure apparatus EX of this embodiment is a liquid immersion exposure apparatus to which a liquid immersion method is applied for improving the resolution and substantially widening the depth of focus by substantially shortening the exposure wavelength, which includes a liquid immersion mechanism 1 for filling an optical path space of the exposure light beam EL on a side of an image plane of the projection optical system PL with a liquid LQ. The liquid immersion mechanism 1 includes a nozzle member 70 which is provided in the vicinity of the side of the image plane of the projection optical system PL and has a supply port 18 for supplying the liquid LQ and a recovery port 28 for recovering the liquid LQ, a liquid supply mechanism 10 which supplies the liquid LQ to the side of the image plane of the projection optical system PL via the supply port 18 provided in the nozzle member 70, and a liquid recovery mechanism 20 which recovers the liquid LQ on the side of the image plane of the projection optical system PL via the recovery port 28 provided in the nozzle member 70. Over or above the substrate P (substrate stage PST), the nozzle member 70 is formed into an annular shape to surround a first optical element LS1 which is disposed closest to the image plane of the projection optical system PL among a plurality of optical elements LS1 to LS5 for constituting the projection optical system PL.

At least during projection of the image of the pattern MP of the mask M onto the substrate P, the exposure apparatus EX locally forms a liquid immersion area LR of the liquid LQ larger than the projection area AR and smaller than the substrate P by the liquid LQ supplied from the liquid supply mechanism 10 onto a portion of the substrate P, which includes a projection area AR of the projection optical system PL. In detail, the exposure apparatus EX adopts a local liquid immersion method in which an optical path space between the first optical element LS1 disposed closest to the image plane of the projection optical system PL and the surface of the substrate P arranged on the side of the image plane of the projection optical system PL is filled with a liquid LQ, and projects the pattern MP of the mask M onto the substrate P by irradiating the substrate P with an exposure light beam EL which has passed through the mask M via the projection optical system PL and the liquid LQ between the projection optical system PL and the substrate. The control unit CONT locally forms a liquid immersion area LR of the liquid LQ on the substrate P by supplying a predetermined amount of the liquid LQ onto the substrate P with the liquid supply mechanism 10 and recovering a predetermined amount of the liquid LQ on the substrate P with the liquid recovery mechanism 20.

Also, the exposure apparatus EX includes a measuring unit 30 for measuring the optical property of the liquid LQ. The measuring unit 30 optically measures a property of the liquid LQ supplied by the liquid supply mechanism 10, and is capable of measuring at least one of the refractive index of the liquid LQ and the light transmittance of the liquid LQ. The liquid supply mechanism 10 has a mixing unit 19 for mixing a plurality of liquids, and supplies the liquid LQ prepared or produced by the mixing unit 19 to the side of the image plane of the projection optical system PL.

This embodiment will now be explained as exemplified by a case of use of the scanning type exposure apparatus (so-called scanning stepper) as the exposure apparatus EX in which the substrate P is exposed with the pattern formed on the mask M while synchronously moving the mask M and the substrate P in mutually different directions (opposite directions) in the scanning directions. In the following explanation, the X axis direction is the synchronous movement direction (scanning direction) for the mask M and the substrate P in a horizontal plane, the Y axis direction (non-scanning direction) is the direction which is perpendicular to the X axis direction in the horizontal plane, and the Z axis direction is the direction which is perpendicular to the X axis direction and the Y axis direction and which is coincident with the optical axis AX of the projection optical system PL. The directions of rotation (inclination) about the X axis, the Y axis, and the Z axis are defined as θX, θY, and θZ directions, respectively. The term "substrate" referred to herein includes those obtained by coating a semiconductor wafer surface with a resist (photosensitive material), and the term "mask" includes a reticle formed with a unit pattern to be subjected to the reduction projection onto the substrate.

The illumination optical system IL includes an exposure light source, an optical integrator which uniformizes the illuminance of a light flux radiated from the exposure light source, a condenser lens which collects the exposure light beam EL emitted from the optical integrator, a relay lens system, a field diaphragm which sets an illumination area on the mask M illuminated with the exposure light beam EL, and the like. The predetermined illumination area on the mask M is illuminated with the exposure light beam EL having a uniform illuminance distribution by the illumination optical system IL. Those usable as the exposure light beam EL radiated from the illumination optical system IL include, for example, emission lines (g-ray, h-ray, i-ray) radiated from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm). In this embodiment, the ArF excimer laser beam is used.

The mask stage MST is movable while holding the mask M. The mask stage MST holds the mask M by means of vacuum attraction (or electrostatic attraction). The mask stage MST is two-dimensionally movable in a plane perpendicular to the optical axis AX of the projection optical system PL, that is, in an XY plane and finely rotatable in the θZ direction while holding the mask M by driving of the mask stage driving unit MSTD having a linear motor, etc., to be controlled by the control unit CONT.
The mask stage MST is also finely movable in the Z axis direction and θX and θY directions. On the mask stage MST, a movement mirror 81 which moves together with the mask stage MST, is fixedly provided. A laser interferometer 82 is provided at a position facing the movement mirror 81. The position in the two-dimensional direction and the angle of rotation in the θZ direction (including the angles of rotation in θX and θY directions according to circumstances) of the mask M on the mask stage MST are measured in real-time by the laser interferometer 82. The result of measurement obtained by the laser interferometer 82 is outputted to the control unit CONT. The control unit CONT drives the mask stage driving unit MSTD based on the result of measurement obtained by the laser interferometer 82 and controls the position of the mask M held on the mask stage MST.

The projection optical system PL projects the pattern of the mask M onto the substrate P at a predetermined projection magnification β to perform the exposure. The projection optical system PL includes a plurality of optical elements LS1 to LS5, and these optical elements LS1 to LS5 are held by a barrel PK. In this embodiment, the projection optical system PL is the reduction system in which the projection magnification β is, for example, 1/4, 1/5, or 1/8. The projection optical system PL may be any one of the 1x magnification system and the magnifying system. The projection optical system PL may be any one of the dioptric system including no catoptric element, the catoptric system including no dioptric element, and the catadioptric system including dioptric and catoptric elements.

Among the projection optical system PL, the first optical element LS1 disposed closest to the image plane of the projection optical system PL, has a concave surface portion 2 which comes into contact with the liquid LQ in the liquid immersion area LR. The concave surface portion 2 is provided on the lower surface T1 facing the substrate P of the first optical element LS1, and is recessed so as to separate away from the substrate P. The concave surface portion 2 is in a curved shape. On the other hand, the upper surface T2 of the first optical element LS1 is in a curved shape which is protruded so as to swell toward the side of the object face (the side of the mask) of the projection optical system PL.

An image formation characteristic adjusting unit LC as disclosed in, for example, Japanese Patent Application Laid-open No. 11-195602 is provided in the projection optical system PL. The image formation characteristic adjusting unit LC is capable of adjusting the image formation characteristic such as the aberration of the projection optical system PL and the position of the image plane by driving a specific optical element among the plurality of optical elements LS1 to LS5 included in the projection optical system PL. As the image formation characteristic adjusting unit LC, an adjusting mechanism which adjusts a pressure of gas between some optical elements may also be used.

The substrate stage PST has a substrate holder PH which holds the substrate P, and can move the substrate holder PH on the side of the image plane of the projection optical system PL. The substrate holder PH holds the substrate P by means of, for example, the vacuum attraction, etc. A recess portion 86 is provided on the surface of the substrate stage PST, and the substrate holder PH for holding the substrate P is disposed in the recess portion 86. The upper surface 87 other than the recess portion 86 of the substrate stage PST is a flat surface (flat portion) which has approximately the same height (flush with) as that of the surface of the substrate P held by the substrate holder PH.

The substrate stage PST is two-dimensionally movable in an XY plane and finely rotatable in the θZ direction on the base member BP by driving of the substrate stage driving unit PSTD including a linear motor and the like, controlled by control unit CONT in the state that the substrate P has been held via the substrate holder PH. Furthermore, the substrate stage PST is also movable in the Z axis direction, θX direction, and θY direction. Therefore, the surface of the substrate P supported by the substrate stage PST is movable in six directions of degree of freedom of the X axis, Y axis, Z axis, θX, θY, and θZ directions. A movement mirror 83 which moves together with the substrate stage PST is fixedly provided on a side surface of the substrate stage PST. A laser interferometer 84 is provided on a position facing the movement mirror 83. The position in the two-dimensional direction and the angle of rotation of the substrate P on the substrate stage PST are measured in real-time by the laser interferometer 84. The exposure apparatus EX includes a focus/leveling-detecting system (not shown) using an oblique incidence method which detects surface position information of the surface of the substrate P supported by the substrate stage PST as disclosed in, for example, Japanese Patent Application Laid-open No. 8-37149. The focus/leveling-detecting system detects surface position information (positional information in the Z axis direction and inclination information of the substrate P in the θZ and θY directions) of the surface of the substrate P. The focus/leveling-detecting system may adopt a method using a capacitance type sensor. The result of measurement obtained by the laser interferometer 84 is outputted to the control unit CONT. The result of measurement obtained by the focus/leveling-detecting system is also outputted to the control unit CONT. The control unit CONT drives the substrate stage driving unit PSTD, and controls the focus position (Z position) and angles of inclination (θX, θY) of the substrate P based on the result of detection by the focus/leveling-detecting system to mach the surface of the substrate P with the image plane of the projection optical system PL, and performs the positional control in the X axis direction, Y axis direction, and θZ direction of the substrate P based on the result of measurement made by the laser interferometer 84. The detection of the surface position information of the surface of the substrate P can be performed in the same manner as the method disclosed in, for example, Japanese Patent Application Laid-open No. 2004-207710.

Next, the liquid supply mechanism 10 and the liquid recovery mechanism 20 of the liquid immersion mechanism 1 will be described. In the following description, the refractive index of the liquid and the refractive index of an optical element with respect to the exposure light beam EL (ArF laser beam: wavelength 193nm) will be simply referred to as "refractive index".

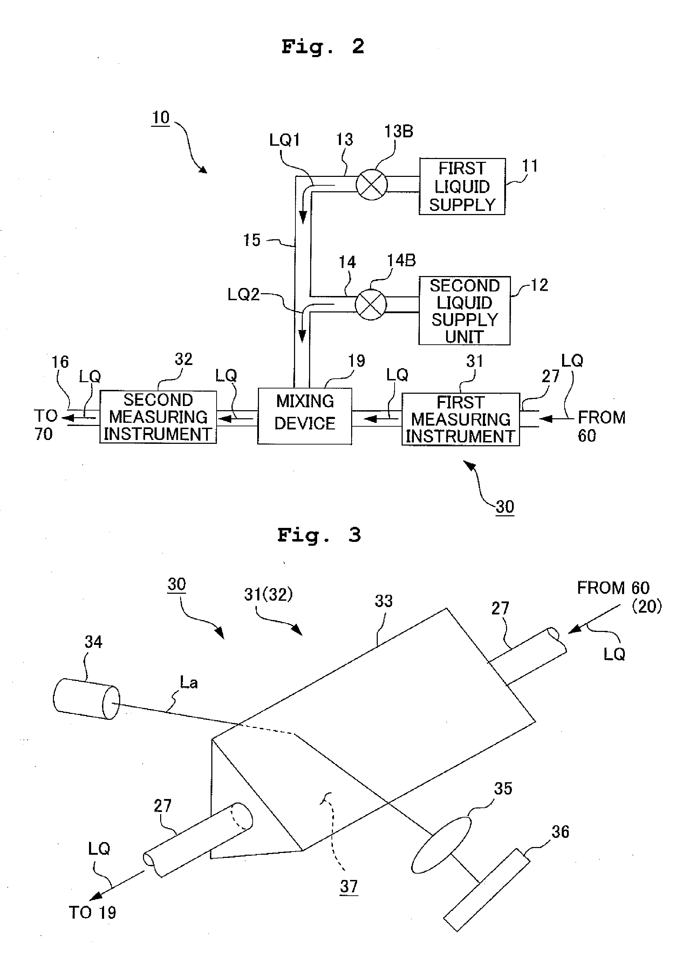

Fig. 2 is a drawing illustrating the liquid supply mechanism 10. As shown in Fig. 1 and Fig. 2, the liquid supply mechanism 10 of this embodiment has a first liquid supply section 11 which is capable of feeding a first liquid LQ1, a second liquid supply section 12 which is capable of feeding a second liquid LQ2, and a mixing unit 19 which mixes the first liquid LQ1 fed from the first liquid supply section 11 and the second liquid LQ2 fed from the second liquid supply section 12, and supplies the liquid LQ prepared by the mixing unit 19 to the side of the image plane of the projection optical system PL. The first liquid LQ1 and the second liquid LQ2 are liquids having mutually different optical property, and the mixing unit 19 mixes the two liquids LQ1 and LQ2 having mutually different optical property. In the following description, the liquid prepared by the mixing unit 19 is referred to as "liquid LQ".

Each of the first and second liquid supply sections 11 and 12 includes a tank for accommodating the first or second liquid LQ1 or LQ2, a pressurizing pump, a temperature controller for adjusting the temperature of the first or second liquid LQ1 or LQ2 to be supplied, a filter unit for removing foreign bodies (including particles or bubbles) in the first or second liquid LQ1 or LQ2, and the like. However, it is not necessary that the exposure apparatus EX includes all of the tank, the pressurizing pump, the temperature controller, the filter unit, and the like of the liquid supply mechanism 10. Facilities in a factory in which the exposure apparatus EX is installed, can be used instead of these. One end portion of a first supply tube 13 is connected to the first liquid supply section 11, and the other end portion of the first supply tube 13 is connected to a collecting tube 15. One end portion of a second supply tube 14 is connected to the second liquid supply section 12, and the other end of the second supply tube 14 is connected to the collecting tube 15. The first liquid LQ1 fed out from the first liquid supply section 11 flows through the first supply tube 13, and is then supplied to the mixing unit 19 via the collecting tube 15. The second liquid LQ2 fed out from the second liquid supply section 12 flows through the second supply tube 14, and is then supplied to the mixing unit 19 via the collecting tube 15.

Herein, those usable as the liquid LQ which is prepared by the mixing unit 19 and supplied to the side of the image plane of the projection optical system PL by the liquid supply mechanism 10, include, for example, a liquid which contains a predetermined liquid having a C-H bond or O-H bond such as isopropanol (refractive index: about 1.50) or glycerol (refractive index: about 1.61), a liquid which contains a predetermined liquid (organic solvent) such as hexane, heptane, decane, or the like, or a liquid which contains pure water. Alternatively, the liquid LQ which is supplied by the liquid supply mechanism 10, may be a mixture of pure water and a predetermined substance of a base or an acid that releases positive ion or negative ion such as H⁺, Cs⁺, K⁺, Cl⁻, SO₄²⁻ , and P0₄²⁻ or the like. Also, the liquid LQ may be a mixture of pure water and a predetermined substance such as particles of an Al oxide. The first and second liquid supply sections 11 and 12 feed the mutually different kind of the first and second liquids LQ1 and LQ2 (containing the predetermined substance as described above) for preparing the liquid LQ as described above to the mixing unit 19, and then, in the mixing unit 19, the first and second liquids LQ1 and LQ2 supplied from the first and second liquid supply sections 11 and 12, are mixed in order to prepare the liquid LQ. In this embodiment, as the first liquid LQ1, glycerol (refractive index: about 1.61) is supplied, and as the second liquid LQ2, isopropanol is supplied.

The first and second liquid supply sections 11 and 12 may supply the same kind (material) of liquid as the first and second liquids LQ1 and LQ2. For example, the first liquid supply section 11 supplies pure water having a first temperature as the first liquid LQ1, and the second liquid supply section 12 supplies pure water having a second temperature different from the first temperature as the second liquid LQ2. In this case, although, the materials of the first and second liquids LQ1 and LQ2 are the same, their temperatures are different from each other, so that the optical properties (refractive indexes) of the first and second liquids LQ1 and LQ2 are mutually different. In the mixing unit 19, a liquid LQ corresponding to the first and second temperatures is prepared.

As the first and second liquids LQ1 and LQ2, liquids which are made from the same material and have mutually different properties or ingredients (when the liquids are water, mutually different water qualities), may be used. Herein, the liquid's properties or ingredients may include specific resistance value of the liquid, total organic carbon (TOC) contained in the liquid, foreign bodies including particles or bubbles in the liquid, dissolved gases including dissolved oxygen (DO) and dissolved nitrogen (DN), metal ion content, silica concentration in the liquid, and viable bacteria, etc.

As the liquid LQ which is supplied by the liquid supply mechanism 10 as described above, a liquid capable of transmitting an ArF excimer laser beam is usable. It is preferable that the liquid LQ has a small absorption coefficient for an ArF excimer laser beam and a small temperature dependency, and is stable with respect to the projection optical system PL and a resist coated on the surface of the substrate P.

In addition, the first and second supply tubes 13 and 14 have first and second valves 13B and 14B, respectively. The operations of the first and second valves 13B and 14B are controlled by the control unit CONT. The control unit CONT adjusts the first and second valves 13B and 14B(the degrees of opening of the first and second valves 13B and 14B) to adjust the supply amounts per unit time of the respective first and second liquids LQ1 and LQ2 to be supplied to the mixing unit 19 via the first and second supply tubes 13 and 14 and the collecting tube 15 from the first and second liquid supply sections 11 and 12.

In addition, the liquid LQ returned from the liquid recovery mechanism 20 can also be supplied to the mixing unit 19. The liquid LQ returned from the liquid recovery mechanism 20 is supplied to the mixing unit 19 through a return tube 27. The mixing unit 19 mixes the first and second liquids LQ1 and LQ2 supplied from the first and second liquid supply sections 11 and 12 via the first and second supply tubes 13 and 14 and the collecting tube 15, and the liquid LQ supplied from the liquid recovery mechanism 20 via the return tube 27. In addition, one end portion of the supply tube 16 is connected to the mixing unit 19, and the other end portion thereof is connected to the nozzle member 70. In the nozzle member 70, a supply internal flow channel whose one end portion thereof is connected to the supply port 18, is formed, and the other end portion of the supply tube 16 is connected to the other end portion of the supply internal flow channel of the nozzle member 70. The liquid LQ prepared by the mixing unit 19 is supplied to the nozzle member 70 via the supply tube 16, and after flowing via the supply internal flow channel of the nozzle member 70, the prepared liquid LQ is supplied onto the substrate P arranged on the side of the image plane of the projection optical system PL from the supply port 18.

In Fig. 1, in order to recover the liquid LQ on the side of the image plane of the projection optical system PL, the liquid recovery mechanism 20 has a liquid recovery section 21 which can recover the liquid LQ and a recovery tube 26 in which one end portion thereof is connected to the liquid recovery section 21. The other end portion of the recovery tube 26 is connected to the nozzle member 70. The liquid recovery section 21 includes, for example, a vacuum system (sucking unit) such as a vacuum pump or the like, a gas-liquid separator which separates the recovered liquid LQ and gases, a tank for accommodating the recovered liquid LQ, and the like. It is not necessary that the exposure apparatus EX is provided with all of the vacuum system, the gas-liquid separator, the tank, and the like of the liquid recovery mechanism 20. The facilities in a factory in which the exposure apparatus EX is installed, may be used instead of these. In the nozzle member 70, an recovery internal flow channel, in which one end portion thereof is connected to the recovery port 28, is formed, and the other end of the recovery tube 26 is connected to the other end portion of the recovery internal flow channel of the nozzle member 70. By driving the vacuum system of the liquid recovery section 21, the liquid LQ on the substrate P arranged on the side of the image plane of the projection optical system PL flows into the recovery internal flow channel from the recovery port 28 to recover by the liquid recovery section 21 via the recovery tube 26.

Herein, the supply port 18 is provided in the lower surface 70 facing the substrate P of the nozzle member 70 so as to surround the projection area AR of the projection optical system PL. The recovery port 28 is provided in the lower surface 70A of the nozzle member 70 and at the outside of the supply port 18 with respect to the projection region AR. The recovery port 28 is formed into an annular slit shape in the lower surface 70A of the nozzle member 70. The liquid LQ of the liquid immersion area LR is filled in a space between the lower surface T1 of the first optical element LS1 and the lower surface 70A of the nozzle member 70, and the substrate P.

The liquid recovery mechanism 20 further has a process unit 60 which performs predetermined treatment to the recovered liquid LQ. The liquid recovery mechanism 20 returns the liquid LQ treated by the process unit 60 to the mixing unit 19 of the liquid supply mechanism 10 via the return tube 27. The process unit 60 cleans the recovered liquid LQ, and has, for example, a filter unit, a distillation unit and the like. The liquid LQ recovered by the liquid recovery mechanism 20 comes into contact with the resist (photosensitive material) on the surface of the substrate P, so that the recovered liquid LQ may contain impurities generated from the substrate P (resist). The liquid LQ recovered by the liquid recovery mechanism 20 is recovered after coming into contact with the atmosphere, so that the recovered liquid LQ may contain impurities (including gases) in the atmosphere. Therefore, the liquid recovery mechanism 20 cleans a part of the recovered liquid LQ by the process unit 60, and returns the cleaned liquid LQ to the mixing unit 19 of the liquid supply mechanism 10. The liquid recovery mechanism 20 does not return a part of the remaining recovered liquid LQ to the liquid supply mechanism 10 but discharges (discards) it to the outside of the exposure apparatus EX. The liquid supply mechanism 10 again supplies the liquid LQ returned by the liquid recovery mechanism 20 to the side of the image plane of the projection optical system PL and reuses it for liquid immersion exposure. The liquid recovery mechanism 20 may return the whole of the recovered liquid LQ to the liquid supply mechanism 10.

The liquid supply mechanism 10 includes a measuring unit 30 which measures optical property of the liquid LQ. The measuring unit 30 measures the optical property of the liquid LQ to be supplied to the side of the image plane of the projection optical system PL by the liquid supply mechanism 10, and includes a first measuring instrument 31 provided at an intermediate position of the return tube 27 between the process unit 60 of the liquid recovery mechanism 20 and the mixing unit 19, and a second measuring instrument 32 provided at an intermediate position of the supply tube 16 between the mixing unit 19 and the nozzle member 70. The first measuring instrument 31 measures optical property of the liquid LQ which is returned from the process unit 60 of the liquid recovery mechanism 20 and is a liquid before being supplied to the mixing unit 19. The second measuring instrument 32 measures optical property of the liquid LQ which is prepared by the mixing unit 19 and is a liquid before being supplied to the side of the image plane of the projection optical system PL via the nozzle member 70. The first measuring instrument 31 and the second measuring instrument 32 have constructions almost equivalent to each other, and can measure at least one of the refractive index of the liquid LQ and the transmittance of the liquid LQ.

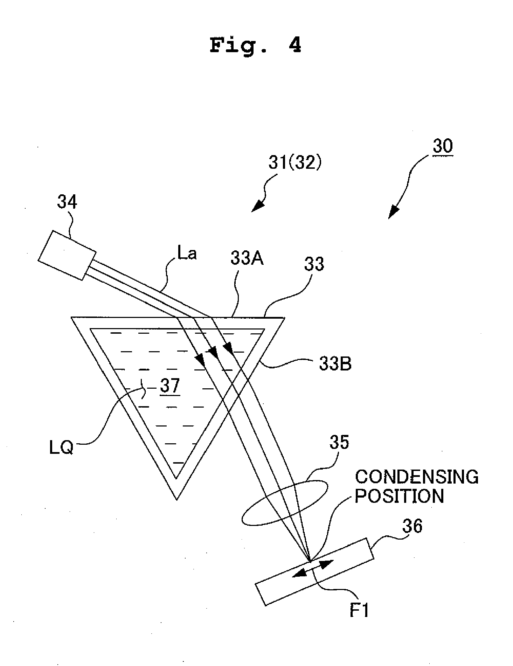

Hereinafter, the first measuring instrument 31 will be described with reference to Fig. 3 and Fig. 4. Fig. 3 is a schematic perspective view illustrating the first measuring instrument 31, and Fig. 4 is a sectional view thereof. As described above, the first measuring instrument 31 and the second measuring instrument 32 have constructions almost equivalent to each other. Therefore, a description of the second measuring instrument 32 is omitted.

In Fig. 3 and Fig. 4, the first measuring instrument 31 includes a flow channel forming member 33 which is provided at the intermediate position of the return tube 27 and flows the liquid LQ, a projecting section 34 which irradiates a measuring light beam La to the flow channel forming member 33, an optical element (light condensing optical system) 35 which condenses (focuses) the measuring light beam La passed through the flow channel forming member 33, and an image pickup device 36 which has a CCD and the like, for receiving the measuring light beam La via the optical element 35. The measuring light beam La, which is radiated from the projecting section 34 to the flow channel forming member 33, is a collimated light beam having an appropriate sectional area. The distance between the optical element 35 and the image pickup device 36 are set almost equal to the focal length of the optical element 35, and the optical element 35 condenses the measuring light beam La which has passed through the optical element 35 onto the image pickup device 36. The measuring light beam La outputted from the projecting section 34 has almost the same wavelength (193 nm as a wavelength of the ArF excimer laser beam) as that of the exposure light beam EL.

The flow channel forming member 33 is formed of a material which can transmit the measuring light beam La (exposure light beam EL) such as silica glass, calcium fluoride or the like, and is a tubular member formed into a triangle in a sectional view. The flow channel forming member 33 has a function as a prism. Inside the flow channel forming member 33, a flow channel 37 in which the liquid LQ flows is formed. One end portion of the flow channel 37 formed by the flow channel forming member 33 is connected to the return tube 27, and the liquid LQ returned from the process unit 60 of the liquid recovery mechanism 20 flows into the one end portion of the flow channel 37 via the return tube 27. The other end portion of the flow channel 37 formed by the flow channel forming member 33 is connected to the mixing unit 19 via the return tube 27. The liquid LQ which has flown into the one end portion of the flow channel 37, flows through the flow channel 37 and then flows out from the other end portion thereof, and is supplied to the mixing unit 19 via the return tube 27. Namely, in the flow channel 37 of the flow channel forming member 33, the liquid LQ to be supplied to the side of the image plane of the projection optical system PL by the liquid supply mechanism 10 flows. The flow channel 37 is filled with the liquid LQ to be supplied to the side of the image plane of the projection optical system PL.

When measuring the optical property of the liquid LQ with the first measuring instrument 31, the control unit CONT irradiates a first surface 33A of the flow channel forming member 33 with the measuring light beam La from the projecting section 34 by oblique incidence in a state that the flow channel 37 of the flow channel forming member 33 is filled with the liquid LQ. The flow channel forming member 33 is transmissive the measuring light beam La, so that the measuring light beam La which has been irradiated the flow channel forming member 33, is radiated to the liquid LQ flowing in the flow channel 37. Then, the measuring light beam La which has been irradiated the liquid LQ flowing in the flow channel 37, is projected from a second surface 33B of the flow channel forming member 33 to the outside after passing through the liquid LQ. The measuring light beam La which has been projected from the second surface 33B of the flow channel forming member 33, is condensed onto the image pickup device 36 by the optical element 35.

The condensing position of the measuring light beam La on the image pickup device 36 changes depending on the optical property of the liquid LQ flowing in the flow channel 37. In detail, the angle of incidence and angle of emergence on the interface between the first surface 33A and the liquid LQ change according to the refractive index of the liquid LQ filling the flow channel 37 with respect to the measuring light beam La, and accordingly, the optical path of the measuring light beam La which passes through the liquid LQ varies. As a result, the condensing position of the measuring light beam La on the image pickup device 36, that is, the light receiving position of the measuring light beam La by the image pickup device 36 change as shown by the arrow F1 in Fig. 4. The result of light receiving by the image pickup device 36 is outputted to the control unit CONT. In the storage unit MRY connected to the control unit CONT, the relationship between the light receiving position of the measuring light beam La on the image pickup device 36 and the refractive index of the liquid LQ flowing in the flow channel 37 is stored in advance. The control unit CONT can obtain the refractive index of the liquid LQ flowing in the flow channel 37 with respect to the measuring light beam La based on the result of light receiving by the image pickup device 36 and the information stored in the storage unit MRY.

According to the light transmittance of the liquid LQ flowing in the flow channel 37 with respect to the measuring light beam La, the light receiving amount of the measuring light La on the image pickup device 36 changes. The result of light receiving by the image pickup device 36 is outputted to the control unit CONT. In the storage unit MRY connected to the control unit CONT, the relationship between the light receiving amount of the measuring light beam La on the image pickup device 36 and the light transmittance of the liquid LQ flowing in the internal flow channel 37 is stored in advance. The control unit CONT can also obtain a light transmittance of the liquid LQ flowing in the internal flow channel 37 with respect to the measuring light beam La based on the result of light receiving by the image pickup device 36 and the information stored in the storage unit MRY.

The measuring light beam La has almost the same wavelength as that of the exposure light beam EL, so that the control unit CONT can obtain the refractive index and light transmittance of the liquid LQ with respect to the exposure light beam EL. Thus, the first measuring instrument 31 optically obtains the optical property including at least one of the refractive index and the light transmittance of the liquid LQ with respect to the exposure light beam EL with the measuring light beam La. Similarly, the second measuring instrument 32 optically obtains the optical property of the liquid LQ which has passed through the mixing unit 19 with the measuring light beam La.

Although, the measuring light beam La has almost the same wavelength as that of the exposure light beam EL, the projecting section 34 may have a light source capable of generating the measuring light beam La having the same wavelength as that of the exposure light beam EL. In addition, the exposure light beam EL generated from the illumination optical system IL is branched by a branching unit and a part of the branched exposure light beam EL may be used as the measuring light beam La. In this case, the projecting section 34 constructs a part of the branching unit. When the projecting section 34 is provided with the light source, in this embodiment, since the exposure light beam EL is an ArF excimer laser beam, a combination of a solid laser or an ArF excimer lamp of 193 nm, a deuterium lamp, or the like and a band-narrowing element (filter, grating, etc.) may be used as the light source of the projecting section 34, and the wavelength of the light outputted from the light source may be matched with the wavelength of the exposure light beam EL. The measuring light beam La which is radiated from the projecting section 34 to the flow channel forming member 33, may have a wavelength different from that of the exposure light beam EL. In this case, the relationship between the light receiving position (or light receiving amount) on the image pickup device 36 when the measuring light beam La having the same wavelength as that of the exposure light beam EL and the light receiving position (or light receiving amount) on the image pickup device 36 when the measuring light beam La having a wavelength different from that of the exposure light beam EL, is obtained in advance. Then, by correcting the result of measurement (light receiving position, light receiving amount) when a measuring operation is performed by using the measuring light beam La having a wavelength different from that of the exposure light beam EL based on the relationship, information of the refractive index and the light transmittance of the liquid LQ with respect to the exposure light beam EL can be obtained.

The first and second measuring instruments 31 and 32 optically measure the property of the liquid LQ flowing in the flow channel 37 which is a part of the supply channel of the liquid supply mechanism 10. By measuring the optical property of the liquid LQ while the liquid LQ flows, the measurement can be performed without a great change of the temperature of the liquid LQ, and the measurement accuracy can be improved. In the case of the liquid immersion exposure of the substrate P, the liquid LQ is supplied onto the substrate P by the liquid supply mechanism 10. Since the property of the liquid LQ flowing in the supply channel of the liquid supply mechanism 10 can be directly measured, the property of the liquid LQ can always be measured (monitored) while performing liquid immersion exposure of the substrate P. Namely, the operation for measuring the liquid LQ can be performed while supplying the liquid LQ, so that without stopping the operation of the exposure apparatus EX, the operation for measuring the liquid LQ can be performed. Therefore, inconvenience such as lowering in operating rate of the exposure apparatus EX can be prevented.

In this embodiment, the flow channel forming member 33 constructs a part of the supply channel for the liquid LQ to be supplied to the side of the image plane of the projection optical system PL by the liquid supply mechanism 10, and the whole of the liquid LQ flows in the flow channel 37 formed by the flow channel forming member 33. Thereby, the properties of the liquid LQ which is actually supplied to the side of the image plane of the projection optical system PL can be directly measured, so that the measurement accuracy can be improved. On the other hand, it is also considered that a branching tube which branches the return tube 27 or the supply tube 16, is provided, a part of the liquid LQ flows in the branching tube and the liquid LQ flowing in this branching tube is measured with the first or second measuring instrument 31 or 32. By this construction, the first and second measuring instruments 31 and 32 can be made compact.

When foreign bodies such as particles and bubbles are contained in the liquid LQ, the light receiving amount on the image pickup device 36 is reduced, so that the first and second measuring instruments 31 and 32 can also detect whether the liquid LQ contains foreign bodies. In addition, by arranging image pickup devices 36 at a plurality of predetermined positions with respect to the measuring light beam La, respectively, the measuring light beam La which is radiated to the liquid LQ is scattered by foreign bodies when the liquid LQ contains the foreign bodies, so that the first and second measuring instruments 31 and 32 can detect whether the liquid LQ contains foreign bodies based on the scattered light. By the first and second measuring instruments 31 and 32 of this embodiment, chromatic dispersion (Abbe's number) of the liquid LQ with respect to the measuring light beam La (exposure light beam EL) can also be measured. In addition, a temperature sensor may be provided in vicinity of each of the first measuring instrument 31 and second measuring instrument 32 to measure the temperature of the liquid LQ as the optical property of the liquid LQ.

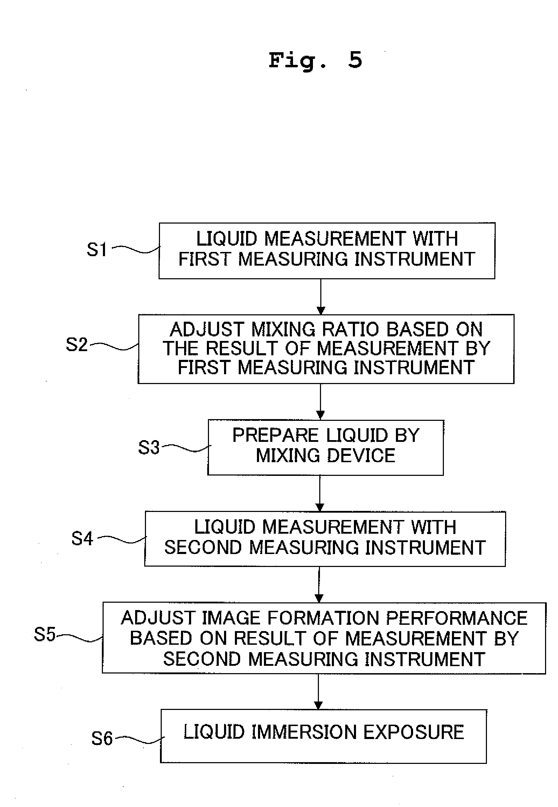

Next, an operation for exposing the substrate P with the exposure apparatus EX having the above described construction will be described with reference to the flowchart of Fig. 5. For exposing the substrate P, the control unit CONT starts an operation for forming the liquid immersion area LR of the liquid LQ by using the liquid immersion mechanism 1. It is assumed that the substrate P to be exposed has already been loaded onto the substrate holder PH. When starting the operation for forming the liquid immersion area LR, the control unit CONT starts the operation for supplying the liquid LQ by the liquid supply mechanism 10 of the liquid immersion mechanism 1 and the operation for recovering the liquid LQ by the liquid recovery mechanism 20 in a state that the first optical element LS1 of the projection optical system PL has been arranged opposite to the upper surface 87, which includes the surface of the substrate P, of the substrate stage PST.

By the operation for supplying the liquid LQ by the liquid supply mechanism 10 and the operation for recovering the liquid LQ by the liquid recovery mechanism 20, the liquid immersion area LR of the liquid LQ is formed on the side of the image plane of the projection optical system PL. The liquid LQ recovered by the liquid recovery mechanism 20 is processed by the process unit 60, and then returned to the liquid supply mechanism 10 via the return tube 27. The control unit CONT measures the optical property of the liquid LQ returned by the liquid recovery mechanism 20 with the first measuring instrument 31 of the measuring unit 30 (Step S1).

The control unit CONT adjusts the first and second valves 13B and 14B provided in the first and second supply tubes 13 and 14 based on the result of measurement by the first measuring instrument 31 to adjust the supply amounts per unit time of the first and second liquids LQ1 and LQ2 to be supplied to the mixing unit 19 from each of the first and second supply sections 11 and 12. In other words, the control unit CONT adjusts the mixing ratio of the first and second liquids LQ1 and LQ2 which are supplied from the first and second liquid supply sections 11 and 12, respectively, based on the result of measurement by the first measuring instrument 31 and mixed by the mixing unit 19 (Step S2) .

The first and second liquids LQ1 and LQ2 have mutually different optical property (refractive index, light transmittance). In this embodiment, the first liquid LQ1 has the refractive index higher than that of the second liquid LQ2. Therefore, in order to adjust the optical property of the liquid LQ prepared by the mixing unit 19 to a desired state, more specifically, in order to adjust at least one of the refractive index and light transmittance of the liquid LQ prepared by the mixing unit 19 to a desired value, the control unit CONT adjusts the mixing ratio of the first and second liquids LQ1 and LQ2 to be mixed by the mixing unit 19 based on the result of measurement by the first measuring instrument 31. The first measuring instrument 31 measures the optical property of the liquid LQ returned from the liquid recovery mechanism 20, so that the control unit CONT can adjust the optical property of the liquid LQ to be prepared by the mixing unit 19 to a desired state only by properly adding appropriate amounts of the first and second liquids LQ1 and LQ2 to the returned liquid LQ by the first and second liquid supply sections 11 and 12 based on the result of measurement by the first measuring instrument 31.

Herein, the relationship between the mixing ratio of the first and second liquids LQ1 and LQ2 and the optical property of the liquid LQ prepared at this mixing ratio is obtained in advance, for example, by an experiment or simulation, and information regarding this relationship is stored in advance in the storage unit MRY connected to the control unit CONT. The control unit CONT adjusts the first and second valves 13B and 14B based on the information stored in the storage unit MRY and the result of measurement by the first measuring instrument 31 to determine a mixing ratio of the first and second liquids LQ1 and LQ2 for obtaining desired optical property of the liquid LQ. Then, the control unit CONT performs the mixing of the first and second liquids LQ1 and LQ2 fed from the first and second liquid supply sections 11 and 12 and the liquid LQ returned from the liquid recovery mechanism 20 by using the mixing unit 19 based on the determined mixing ratio to prepare the liquid LQ (Step S3).

For example, in the case that the first liquid LQ1 has a refractive index higher than that of the second liquid LQ2, when the control unit CONT judges that the refractive index of the liquid LQ is lower than the desired value based on the result of measurement by the first measuring instrument 31, the control unit CONT makes the amount of the first liquid LQ1 to be supplied to the mixing unit greater than the amount of the second liquid LQ2 by controlling the first and second valves 13B and 14B. In addition, in the case that the control unit CONT judges that the refractive index of the liquid LQ is higher than the desired value based on the result of measurement by the first measuring instrument 31, the control unit CONT controls the first and second valves 13B and 14B to increase the amount of the second liquid LQ2 to be supplied to the mixing unit 19 to be greater than the amount of the first liquid LQ. Thereby, the refractive index of the liquid LQ can be set to the desired value.

By the above described method, the optical property of the liquid LQ to be prepared by the mixing unit 19 are adjusted based on the result of measurement by the first measuring instrument 31.

In the mixing unit 19, in order to adjust the refractive index among the optical properties of the liquid LQ, a predetermined substance such as particles of an Al oxide may be also mixed with (added to) the liquid LQ, or a predetermined substance for adjusting the light transmittance of the liquid LQ may be mixed with (added to) the liquid LQ as described above. The predetermined substance to be mixed with the liquid LQ may be a solid or slurry. In addition, solid particles may be dispersed in the liquid LQ, or the solid may be dissolved into the liquid LQ after the solid is put in the liquid LQ.

The liquid LQ prepared by the mixing unit 19 is supplied to the second measuring instrument 32 via the supply tube 16. The control unit CONT measures the optical property of the liquid LQ prepared with the mixing unit 19 by the second measuring instrument 32 of the measuring unit 30. The second measuring instrument 32 measures the liquid LQ of which the optical property has been adjusted based on the result of measurement by the first measuring instrument 31 (Step S4).

The control unit CONT adjusts the image formation characteristic based on the result of measurement by the second measuring instrument 32, to adjust the positional relationship between the position of the image plane formed via the projection optical system PL and the liquid LQ and the surface of the substrate P.

There is a possibility that among the optical properties of the liquid LQ prepared by the mixing unit 19, for example, the refractive index slightly varies, so that the position of the image plane formed via the projection optical system PL and the liquid LQ varies. Alternatively, there is also a possibility that the optical property of the liquid LQ prepared by the mixing unit 19 cannot be completely adjusted to the desired state. Therefore, based on the result of measurement made by the second measuring instrument 32, the control unit CONT adjusts the position of the image plane as an image formation characteristic of the projection optical system PL by driving a specific optical element among the plurality of optical elements LS1 to LS5 of the projection optical system PL or adjusting the internal pressure of the barrel PK with the image formation characteristic adjusting unit LC provided in the projection optical system PL. Alternatively, the image formation characteristic adjusting unit LC can also adjust the image formation characteristic of the projection optical system PL by performing temperature adjustment of the specific optical element among the optical elements LS1 to LS5 of the projection optical system PL to change the temperature of a specific optical element and/or by changing the internal temperature of the barrel PK. The control unit CONT can match, for example, the position of the image plane formed via the projection optical system PL and the liquid LQ with the surface of the substrate P by adjusting the image formation characteristic according to the optical property (refractive index) of the liquid LQ.

Furthermore, the control unit CONT may control the driving of the substrate stage PST via the substrate stage driving unit PSTD based on the optical property (refractive index) of the liquid LQ instead of or by using together the adjustment of the projection optical system PL by the image formation characteristic adjusting unit LC. In this case, the substrate stage driving unit PSTD has a function as an adjusting unit for adjusting the position of the substrate stage PST.

For example, when the refractive index of the liquid LQ is higher than the desired value, the position of the image plane formed via the projection optical system PL and the liquid LQ shifts toward the -Z direction in comparison with the position of the image plane formed via the projection optical system PL and the liquid LQ when the refractive index of the liquid LQ is at the desired value. Therefore, in order to match the position of the image plane formed via the projection optical system PL and the liquid LQ with the surface of the substrate P, the control unit CONT shifts the substrate stage PST holding the substrate P toward the -Z direction by the substrate stage driving unit PSTD based on the result of measurement by the second measuring instrument 32.

Alternatively, the mask stage MST holding the mask M may be driven via the mask stage driving unit MSTD. In this case, the mask stage driving unit MSTD has a function as an adjusting unit for adjusting the image formation characteristic. Alternatively, it is also possible that a temperature controller for finely adjusting the temperature of the liquid LQ is arranged between the nozzle member 70 and the second measuring instrument 32 to adjust the temperature of the liquid LQ to be supplied to the side of the image plane of the projection optical system PL. Alternatively, the illumination optical system IL (exposure light source) may be adjusted to adjust the wavelength of the exposure light beam EL. Alternatively, since the refractive index of the liquid LQ varies due to the pressure of the liquid LQ as well, the position of the image plane formed via the projection optical system PL and the liquid LQ may be adjusted by adjusting the pressure of the liquid LQ. In the case of adjusting the pressure of the liquid LQ, for example, a second port is provided in the nozzle member 70 which is different from the supply port 18 and the recovery port 28. Then, via the second port, the liquid LQ is added to or partially recovered from the liquid immersion area LR of the liquid LQ formed based on the liquid supply operation and the liquid recovery operation via the supply port 18 and the recovery port 28. Thereby, the pressure of the liquid LQ filled in the optical path space between the projection optical system PL and the substrate P can be adjusted. Alternatively, by adjusting the pressure in a chamber accommodating the exposure apparatus EX, the pressure of the liquid LQ filled in the optical path space between the projection optical system PL and the substrate P can also be adjusted.

In this case, the relationship between the optical property of the liquid LQ and the position of the image plane to be formed via the projection optical system PL and the liquid LQ is obtained in advance through, for example, an experiment or simulation, and information regarding this relationship is stored in advance in the storage unit MRY connected to the control unit CONT. The control unit CONT can match the position of the image plane to be formed via the projection optical system PL and the liquid LQ with the surface of the substrate P by using at least one of the adjusting mechanisms including the image formation characteristic adjusting unit LC, the substrate stage driving unit PSTD, the mask stage driving unit MSTD, the temperature controller, and the like, based on the information stored in the storage unit MRY and the result of measurement by the second measuring instrument 32. The exposure apparatus EX is not necessarily provided with all of the above-described adjusting mechanisms, and each of the adjusting mechanisms are arbitrarily installed in the exposure apparatus EX as appropriate.

Not only in the case that the image plane to be formed through the liquid LQ changes according to the optical property of the liquid LQ, but also in the case that other image formation characteristic such as wavefront aberration, distortion aberration or the like change according to the optical property (refractive index) of the liquid LQ, adjustment may be performed in the same manner based on the optical property of the liquid LQ measured by the second measuring instrument 32. As well as the refractive index of the liquid LQ, in the case that, among the optical properties of the liquid LQ prepared by the mixing unit 19, the light transmittance varies or cannot be completely adjusted to a desired state, the control unit CONT can perform optimum exposure amount control (dose control) according to the transmittance of the liquid LQ by adjusting, for example, the illumination optical system IL, etc., including the light source to adjust the irradiance (illuminance) of the exposure light beam EL, by adjusting the scanning speed on the substrate P, by adjusting the pulse emission period of the exposure light beam EL, by adjusting the width of the exposure light beam EL in the scanning direction on the substrate P, or by arbitrarily combining these adjustments based on the result of measurement made by the second measuring instrument 32.

As described above, the control unit CONT adjusts the optical property of the liquid LQ by adjusting the mixing ratio of the first and second liquids LQ1, LQ2, and/or by mixing (adding) a predetermined substance with the liquid LQ based on the result of measurement by the first measuring instrument 31, and adjusts the image formation characteristic (for example, the position of the image plane) based on the result of measurement by the second measuring instrument 32. Then, after completing the adjustment of the optical property of the liquid LQ based on the result of measurement by the first measuring instrument 31, and the adjustment of exposure conditions including, for example, the adjustment of the image formation characteristic based on the result of measurement by the second measuring instrument 32, the control unit CONT performs liquid immersion exposure via the projection optical system PL and the liquid LQ under the adjusted exposure conditions (Step S6).

In the above-described embodiment, it is also possible that while considering the result of measurement by the second measuring instrument 32, the mixing ratio in the mixing unit 19 is adjusted and/or the temperatures of the first liquid LQ1 and/or the second liquid LQ2 supplied from the first liquid supply section 11 and the second liquid supply section 12, are adjusted. Namely, the controller may adjust the mixing ratio in the mixing unit 19 and/or control the temperatures of the first liquid LQ1 and the second liquid LQ2 until the predetermined result of measurement is measured by the second measuring instrument 32 (feedback control). Also, during liquid immersion exposure of the substrate P, the optical property of the liquid LQ is always measured (monitored) by the first and second measuring instruments 31 and 32. Even during the liquid immersion exposure of the substrate P, the control unit CONT can adjust the optical property of the liquid LQ based on monitor information from the first measuring instrument 31 and can adjust the image formation characteristic based on monitor information from the second measuring instrument 32.

The reporting unit INF is connected to the control unit CONT, and the control unit CONT reports the result of measurement by the measuring unit 30 by using the reporting unit INF. The reporting unit INF includes a display unit (display), an warning unit that issues a warning (alarm) by using sounds or light, or the like, and can display, for example, the results of measurements by the first and second measuring instruments 31 and 32 (the information of the refractive index, the light transmittance, etc., of the liquid LQ) on the display unit. Alternatively, when the results of measurements by the first and second measuring instruments 31 and 32 exceed predetermined allowed values, the control unit CONT may issue the warning by using the warning unit. In this case, it is desirable that the allowed value of the result of measurement by the second measuring instrument 32 is determined in view of a range compensable by the adjustment of the image formation characteristic, etc.

In this embodiment, the liquid supply mechanism 10 has a construction which supplies the liquid LQ prepared by the mixing unit 19, and can prepare the liquid LQ having desired optical property by adjusting the mixing ratio of the first and second liquids LQ1 and LQ2 or by mixing the predetermined substance with the liquid LQ. In this embodiment, the mixing unit 19 of the liquid supply mechanism 10 prepares the liquid LQ for filling the optical path space between the lower surface T1 of the first optical element LS1 and the substrate P according to the optical characteristics of the first optical element LS1 which is disposed closest to the image plane of the projection optical system PL among the plurality of optical elements LS1 to LS5 of the projection optical system PL.

The liquid supply mechanism 10 supplies the liquid LQ having the refractive index higher (larger) than the refractive index of the first optical element LS1 that is disposed closest to the image plane of the projection optical system PL among the plurality of optical elements LS1 to LS5 of the projection optical system PL. This liquid LQ with the high refractive index fills the optical path space between the substrate P (or substrate stage PST) arranged on the side of the image plane of the projection optical system PL and the first optical element LS1. In this embodiment, the first optical element LS1 is formed of silica glass, and the refractive index of the liquid LQ is higher than that of silica glass. Herein, the refractive index of silica glass is about 1.5, and the refractive index of the liquid LQ supplied from the mixing unit 19 of the liquid supply mechanism 10 is about 1.6 to 1.8. The first optical element LS1 may be formed of calcium fluoride.

The silica glass as a material forming the first optical element LS1 can transmit an ArF excimer laser beam as the exposure light beam EL. The silica glass is a material with a high refractive index, so that, for example, the size of the first optical element LS1 can be made small, and the entire projection optical system PL and the entire exposure apparatus EX can be made compact. For example, the optical elements LS2 to LS5 may be formed of calcium fluoride and the optical element LS1 may be formed of silica glass, the optical elements LS2 to LS5 may be formed of silica glass and the optical element LS1 may be formed of calcium fluoride, or all the optical elements LS1 to LS5 may be formed of silica glass (or calcium fluoride).

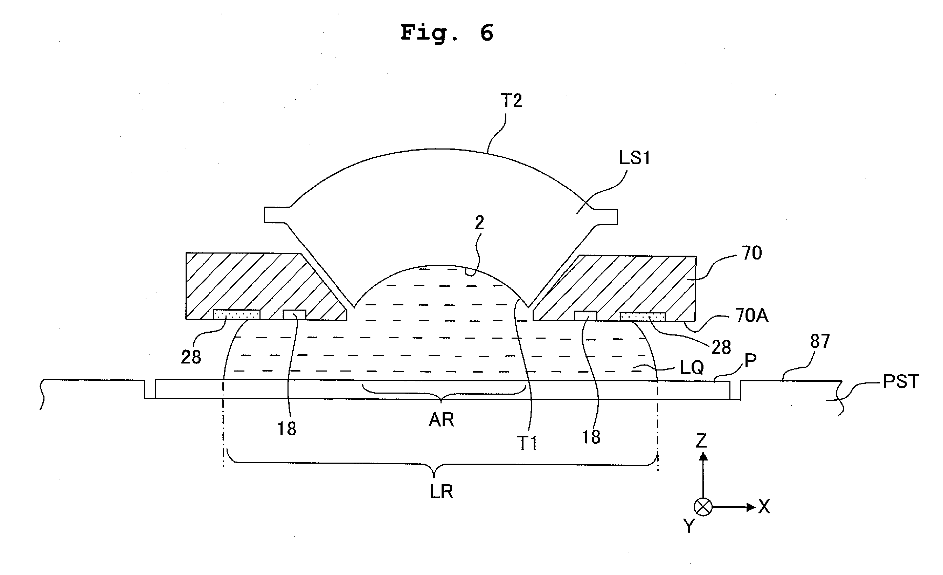

Fig. 6 is an enlarged sectional view showing the vicinity of the first optical element LS1 disposed closest to the image plane of the projection optical system PL. In Fig. 6, in the first optical element LS1, a concave surface portion 2 is formed on the lower surface T1 facing the substrate P. The optical path space on the side of the upper surface T2 of the first optical element LS1 is filled with a gas (nitrogen), and the optical path space on the side of the lower surface T1 of the first optical element LS1 is filled with the liquid LQ. The shape of the upper surface T2 of the first optical element LS1 is a curved shape that is convex so as to swell toward the side of the object face (the side of the mask) of the projection optical system PL.

Thus, by using the liquid LQ having a refractive index higher than that of the first optical element LS1 that is disposed closest to the image plane of the projection optical system PL, the resolution and/or depth of focus can be remarkably improved. The first optical element LS1 has the concave surface portion (curved surface portion) 2 that comes into contact with the liquid LQ, so that when the exposure light beam is made incident from the first optical element LS1 onto the liquid LQ, the total reflection can be suppressed, and then, the exposure light beam EL can be made to satisfactorily reach the side of the image plane of the projection optical system PL.

As described above, by properly mixing a plurality of liquids with the mixing unit 19, the liquid LQ having desired property according to the exposure conditions and the like can be prepared. Therefore, the liquid LQ having, for example, a desired refractive index can be arbitrarily supplied, so that the resolution and depth of focus in the case of exposure through the liquid LQ can be improved, and the exposure accuracy can be maintained at a desired state. The measuring unit 30 for measuring the optical property of the liquid LQ is provided, so that it is possible to grasp the optical property of the liquid LQ and to perform a proper treatment such as adjustment of the optical property of the liquid LQ to a desired state and/or adjustment of the image formation characteristic based on the result of measurement by the measuring unit 30. The measuring unit 30 measures the property of the liquid LQ flowing in the supply passage of the liquid supply mechanism 10, so that it can measure (monitor) the liquid LQ that is immediately before being supplied to the side of the image plane of the projection optical system PL. Therefore, by adjusting the optical property and/or the image formation characteristic of the liquid LQ based on the result of measurement of the liquid LQ immediately before being supplied, the substrate P can be accurately exposed under desired exposure conditions.

When the liquids (functional fluids) to be used as the first liquid LQ1 and/or the second liquid LQ2 as described above, are industrially manufactured in a liquid manufacturing factory (liquid manufacturer), etc., there is a possibility that the property of the liquid varies. Namely, there is a possibility that lot fluctuation occurs in the property of the functional fluids manufactured industrially. In this embodiment, the mixing unit 19 of the liquid supply mechanism 10 prepares the liquid LQ by mixing the first and second liquids LQ1 and LQ2 while properly adjusting the mixing ratio of the first and second liquids LQ1 and LQ2 based on the result of measurement by the measuring unit 30 (first measuring instrument 31). Therefore, for example, by using functional fluids of a first lot as the first liquid LQ1 and using functional fluids of a second lot as the second liquid LQ2, even when lot fluctuation is found in functional fluids formed of the same material, the lot fluctuation can be canceled and a liquid LQ with desired property can be prepared.

In this embodiment, the optical property of the liquid LQ is adjusted based on the result of measurement by the first measuring instrument 31, and the liquid LQ subjected to this adjustment is measured by the second measuring instrument 32. Therefore, even when the optical property of the liquid LQ cannot be completely adjusted to the desired state, since the image formation characteristic, etc., can be adjusted based on the result of measurement by the second measuring instrument 32, the substrate P can be accurately exposed under desired exposure conditions.

In addition, the liquid recovery mechanism 20 returns the recovered liquid LQ to the liquid supply mechanism 10, so that even when the liquid LQ to be used is an expensive or rare liquid industrially produced, the liquid LQ can be reused, and the cost for manufacturing the device can be kept low. There is a possibility that the optical property of the liquid LQ returned to the liquid supply mechanism 10 from the liquid recovery mechanism 20 varies according to, for example, the performance of the process unit 60. However, the optical property of the returned liquid LQ is re-adjusted by the mixing unit 19, so that the recovered and returned liquid LQ can be reused after being adjusted to the desired state.

### Second embodiment

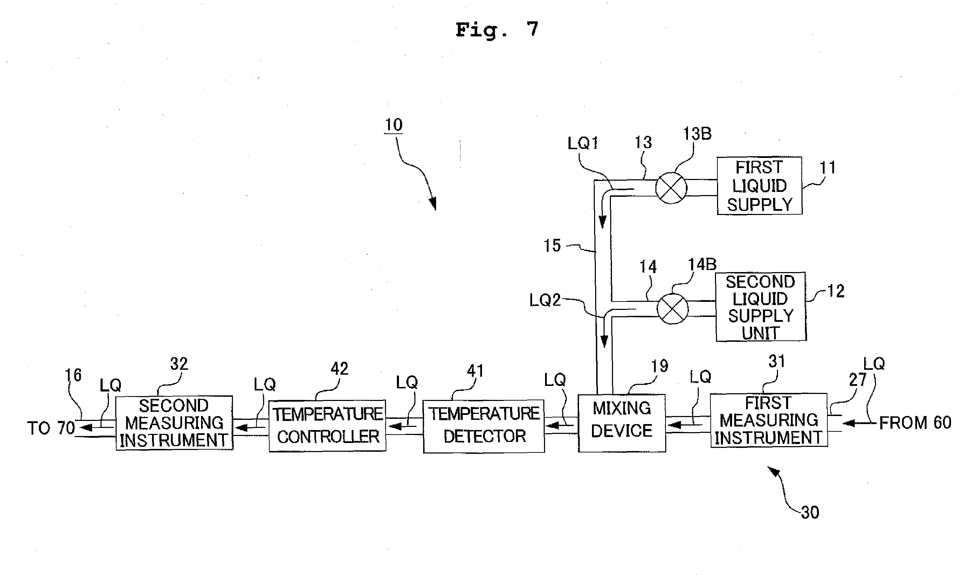

Next, a second embodiment will be described with reference to Fig. 7. In the following description, the same or equivalent constitutive components as those of the first embodiment described above are designated by the same reference numerals, any explanation thereof will be simplified or omitted.

The second embodiment is characterized in that the liquid supply mechanism 10 includes a temperature detector 41 for detecting the temperature of the liquid LQ to be supplied to the side of the image plane of the projection optical system PL and a temperature controller 42 for adjusting the temperature of the liquid LQ. The temperature detector 41 is provided in the middle of the supply tube 16 and detects the temperature of the liquid LQ prepared with the mixing unit 19. The temperature controller 42 is provided between the temperature detector 41 and the second measuring instrument 32 (nozzle member 70) in the supply tube 16, and adjusts the temperature of the liquid LQ after being subjected to temperature detection by the temperature detector 41. The control unit CONT adjusts the temperature of the liquid LQ to be supplied to the side of the image plane of the projection optical system PL by using the temperature controller 42 based on the result of detection by the temperature detector 41.

For example, when the temperature of the liquid LQ is higher than a desired value, the refractive index of the liquid LQ lowers, and the position of the image plane formed via the projection optical system PL and the liquid LQ shifts toward the +Z direction in comparison with the position of the image plane formed via the projection optical system PL and the liquid LQ when the temperature of the liquid LQ is at the desired value. Therefore, in order to match the position of the image plane position to be formed via the projection optical system PL and the liquid LQ with the surface of the substrate P, the control unit CONT adjusts (lowers) the temperature of the liquid LQ by the temperature controller 42. Alternatively, in order to match the position of the image plane to be formed via the projection optical system PL and the liquid LQ with the surface of the substrate P surface, the control unit CONT shifts the substrate stage PST holding the substrate P toward the +Z direction and/or drives the image formation characteristic adjusting unit LC based on the result of detection by the temperature detector 41.

In Fig. 7, when the temperature of the liquid LQ is adjusted by using the temperature controller 42, both of the result of measurement by the second measuring instrument 32 and the result of detection by the temperature detector 41 may be considered. In Fig. 7, the temperature detector 41 can be omitted. In order to obtain the desired value of the refractive index of the liquid LQ to be measured by the second measuring instrument 32, the control unit CONT can set the refractive index of the liquid LQ to the desired value by adjusting the temperature of the liquid LQ by using the temperature controller 42 based on the result of measurement by the second measuring instrument 32.

When a liquid LQ with a refractive index highly dependent on the temperature (liquid LQ in which change in refractive index according to a temperature change is great) is used, there is a possibility that the optical property (refractive index) of the liquid LQ which has been adjusted in temperature by the temperature controller 42 and filled in the optical path space between the projection optical system PL and the substrate P, varies due to temperature variation in a chamber accommodating the exposure apparatus EX, and consequently, due to temperature variation of the environment in the vicinity of the optical path space. Therefore, for example, it is also possible that a temperature measurement instrument capable of measuring the temperature of the environment in the vicinity of the optical path space is provided, and based on the result of measurement by the temperature measurement instrument, temperature adjustment of the liquid LQ by the temperature controller 42 and/or adjustment of the mixing ratio of the first and second liquids LQ1 and LQ2 according to the temperature variation of the environment in the vicinity of the optical path space are performed.

### Third embodiment

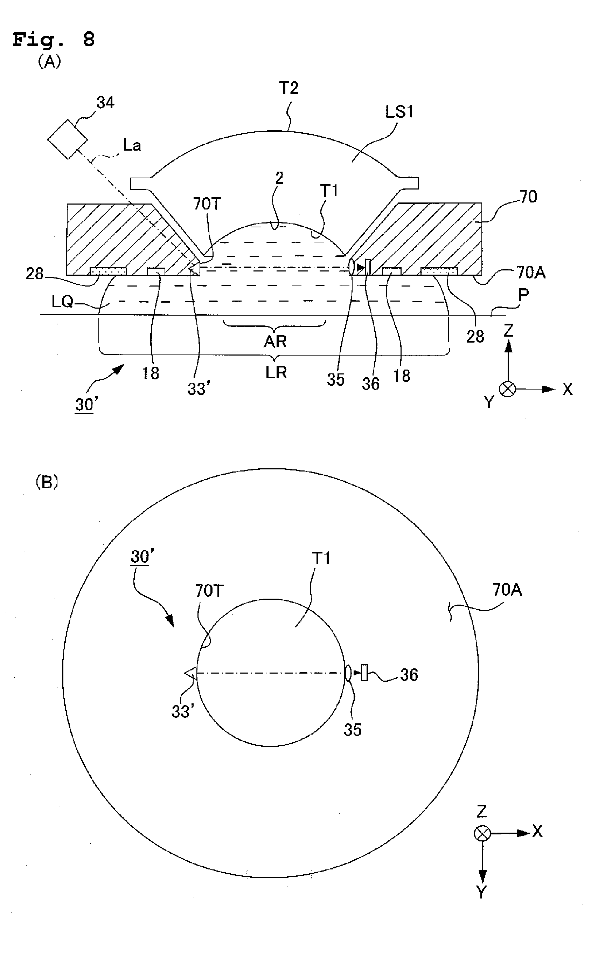

Next, a third embodiment will be described. The third embodiment is characterized in that a measuring unit 30' which measures the optical property of the liquid LQ, is provided on the nozzle member 70. Fig. 8(A) is a side sectional view illustrating the vicinity of the nozzle member 70 according to the third embodiment, and Fig. 8(B) is a drawing of the nozzle member 70 viewed from below.

In Figs. 8, the nozzle member 70 is formed into an annular shape so as to surround the first optical element LS1 that is disposed closest to the image plane of the projection optical system PL among the plurality of optical elements LS1 to LS5 of the projection optical system PL. On the inner side surface 70T of the nozzle member 70, a prism 33' is provided at a predetermined position to come into contact with the liquid LQ in the liquid immersion area LR. On the inner side surface 70T of the nozzle member 70, an optical element (condensing optical system) 35 is provided at a position facing the prism 33' across the liquid immersion area LR.
Furthermore, an image pickup device 36 which receives light via the optical element 35 is provided at a predetermined position of the nozzle member 70. The prism 33' is irradiated with the measuring light beam La from the projecting section 34. The nozzle member 70 shown in Figs. 8 is schematically illustrated. However, in the nozzle member 70, an optical path which is passed the measuring light beam La is secured. The measuring light beam La irradiated the prism 33' from the projector 34 passes through the prism 33', and then passes through the liquid LQ in the liquid immersion area LR. The measuring light beam La that has passed through the liquid LQ is received by the image pickup device 36 via the optical element 35. The measurement principle of the measurement of the optical property of the liquid LQ by the measuring unit 30' is the same as that of the first measuring instrument 31 described with reference to Fig. 3 and Fig. 4. The measuring unit 30' may be used in place of the second measuring instrument 32 of the measuring unit 30, or may be used together with the second measuring instrument 32. In each cases, it is possible that the property of the liquid LQ arranged in the optical path space between the projection optical system PL and the substrate P are measured by using the measuring unit 30' provided on the nozzle member 70, and based on the result of measurement, the optical property and image formation characteristic of the liquid LQ are measured.

### Fourth embodiment

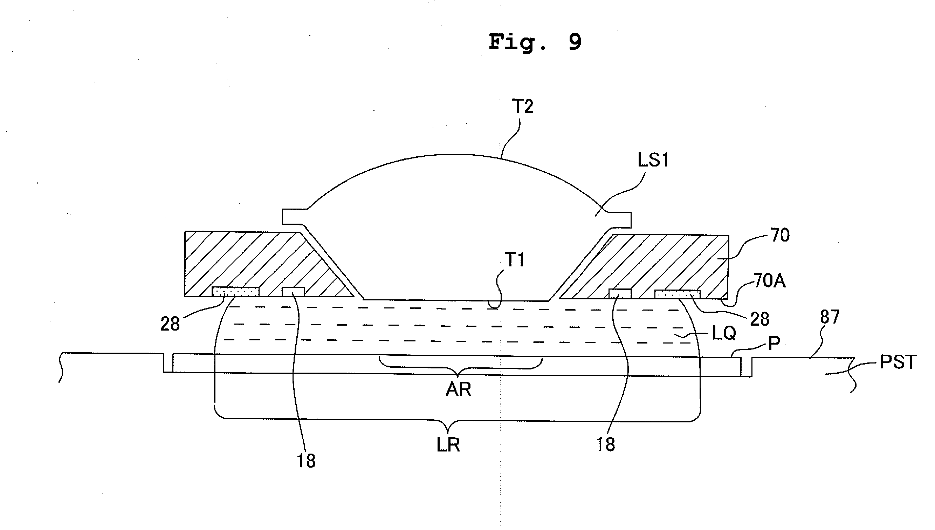

Next, a fourth embodiment will be described with reference to Fig. 9. The fourth embodiment is characterized in that the lower surface T1 of the first optical element LS1 of the projection optical system PL is almost flat, and the mixing unit 19 of the liquid supply mechanism 10 prepares a liquid LQ with a refractive index almost equal to the refractive index of the first optical element LS1. The liquid supply mechanism 10 supplies the liquid LQ prepared by the mixing unit 19.

Fig. 9 is an enlarged sectional view illustrating the vicinity of the first optical element LS1 disposed closest to the image plane of the projection optical system PL. In Fig. 9, in the first optical element LS1, the lower surface T1 facing the substrate P is a flat surface. The optical path space on the side of the upper surface T2 of the first optical element LS1 is filled with a gas (nitrogen), and the optical path space on the side of the lower surface T1 of the first optical element LS1 is filled with the liquid LQ. The shape of the upper surface T2 of the first optical element LS1 is a curved shape that is convex so as to swell toward the side of the object face (the side of the mask) of the projection optical system PL. The refractive index of the first optical element LS1 is almost the same as that of the liquid LQ.

The lower surface T1 of the first optical element LS1 is a flat surface. As described above, the refractive index of the first optical element LS1 and the refractive index of the liquid LQ are the same, so that the exposure light beam EL that reaches the surface of the substrate P is hardly refracted on the lower surface T1 of the first optical element LS1. In this embodiment, by increasing the numerical aperture NA by about n times by using the liquid LQ having a refractive index (n), the resolution and the depth of focus can be remarkably improved. In the fourth embodiment, the refractive index of the first optical element LS1 may be different from that of the liquid LQ.

In the first to fourth embodiments, the liquid supply mechanism 10 mixes the two first and second liquids LQ1 and LQ2 with the mixing unit 19 and supplies the liquid LQ prepared by the mixing unit 19 to the side of the image plane of the projection optical system PL. However, as a matter of course, it is possible that three or more of arbitrary liquids are mixed by the mixing unit 19 and the liquid LQ prepared by the mixing unit 19 is supplied.

Alternatively, the liquid supply mechanism 10 may supply one liquid without mixing the plurality of liquids. In this case, the mixing unit 19 can be omitted in the liquid supply mechanism 10. The control unit CONT measures optical property of the liquid LQ by using the measuring unit 30 (second measuring instrument 32), and based on the result of measurement, can perform adjustment of the image formation characteristic, etc., by using at least one of the adjusting mechanisms including the image formation characteristic adjusting unit LC, the substrate stage driving unit PSTD, the mask stage driving unit MSTD, and the temperature controller, etc. Although at least a part of the liquid LQ recovered by the liquid recovery mechanism 20 is returned to the liquid supply mechanism 10, it is also possible that all the liquid recovered by the liquid recovery mechanism 20 is discarded of and a fresh clean liquid LQ is supplied from the liquid supply mechanism 10. The structure of the liquid immersion mechanism 1 including the nozzle member 70 and the like, is not limited to that described above, and the structures described in, for example, European Patent Application Laid-open No. 1420298, and International Patent Application Laid-open Nos. 2004/055803, 2004/057589, 2004/057590, 2005/29559 can also be used.

The above-described embodiments describe the exposure apparatus in which the optical path space on the light-outgoing side of the first optical element LS1 of the projection optical system PL is filled with the liquid LQ. However, another optical path space may be filled with the liquid (water). For example, as disclosed in International Patent Application Laid-open No. 2004-019128, it is also possible that the optical path space on the light-incoming side of the first optical element LS1 is also filled with the liquid (pure or purified water), and when supplying the liquid into this optical path space, the liquid supply mechanism described with reference to Fig. 2 and Fig. 7 can be applied.

When the numerical aperture NA of the projection optical system is increased by the use of the liquid immersion method as described above, in the random polarized beam conventionally used as an exposure light beam the image formation characteristic is sometimes deteriorated due to the polarization effect. Therefore, it is desirable to use the polarized illumination. In this case, it is preferable that linear polarized illumination adjusted to the longitudinal direction of the line pattern of the line-and-space pattern of the mask (reticle) is performed, so that a large amount of diffracted light of S-polarized component (TE-polarized component), that is, components in the polarization direction along the longitudinal direction of the line pattern is allowed to outgo from the pattern of the mask (reticle). When the space between the projection optical system PL and the resist coated on the surface of the substrate P is filled with a liquid, the diffracted light of the S-polarized component (TE-polarized component) which contributes to improvement in the contrast, has the transmittance on the surface of the resist higher than that of the case in which the space between the projection optical system PL and the resist coated on the surface of the substrate P is filled with air (gas). Therefore, even when the numerical aperture NA of the projection optical system exceeds 1.0, high image formation characteristic can be obtained. An appropriate combination, for example, with a phase shift mask and/or oblique incidence illumination method (especially, dipole illumination method) adjusted to the longitudinal direction of the line pattern as disclosed in Japanese Patent Application Laid-open No. 6-188169, is more effective. Particularly, the combination of the linear polarized illumination method and the dipole illumination method is effective when the periodic direction of the line-and-space pattern is limited to a predetermined one direction, or when hole patterns are densely formed along a predetermined one direction. For example, when a halftone-type phase shift mask having a transmittance of 6% (pattern with a half pitch of about 45 nm) is illuminated by using the linear polarized illumination method together the dipole illumination method, when illumination σ which is provided by a circumscribed circle of two light fluxes forming a dipole on the pupil plane of the illumination system, is 0.95, the radius of each light flux on the pupil plane is 0.125σ, and the numerical aperture of the projection optical system PL is NA=1.2, the depth of focus (DOF) can be increased by 150 nm more than that of the case in which the random polarized beam is used.

A combination of linear polarized illumination and small-σ illumination method (illumination method in which σ value indicating a ratio of the numerical aperture NAi of the illumination system and the numerical aperture NAp of the projection optical system becomes 0.4 or less) is also effective.

In addition, for example, when the ArF excimer laser is used as the exposure light beam, and the substrate P is exposed with a fine line-and-space pattern (for example, lines and spaces of 25 to 50 nm) by using, the projection optical system PL having a reduction magnification of about 1/4, depending on the structure of the mask M (for example, the pattern fineness and the chromium thickness), the mask M functions as a polarizing plate due to the Wave guide effect, and the diffracted light of the S-polarized component (TE-polarized component) is allowed to outgo from the mask M more than the diffracted light of the P-polarized component (TM polarized component) which lowers the contrast. In this case, it is desirable that the linear polarized illumination is used as described above. However, even when the mask M is illuminated with a random polarized light beam and the numerical aperture NA of the projection optical system PL is large, the high resolution performance can be obtained.

When the substrate P is exposed with an extremely fine line-and-space pattern on the mask M, there is a possibility that the P-polarized component (TM polarized component) becomes larger than the S-polarized component (TE-polarized component) due to the Wire Grid effect. However, for example, when the ArF excimer laser is used as the exposure light beam, and the substrate P is exposed with a line-and-space pattern larger than 25 nm by using a projection optical system PL having a reduction magnification of about 1/4, the diffracted light of the S-polarized component (TE-polarized component) is allowed to outgo from the mask M more than the diffracted light of the P-polarized component (TM-polarized component). Therefore, the high resolution performance can be obtained even when the numerical aperture NA of the projection optical system PL is large.

Furthermore, not only the linear polarized illumination (S-polarized illumination) adjusted to the longitudinal direction of the line pattern on the mask (reticle), but the combination of the oblique incidence illumination method and the polarized illumination method in which the linear polarization is effected in a tangential (circumferential) direction of a circle having a center of the optical axis as disclosed in Japanese Patent Application Laid-open No. 6-53120, is also effective. In particular, when the pattern on the mask (reticle) includes not only a line pattern which extends in a predetermined one direction but the pattern also includes line patterns which extend in a plurality of mutually different directions (line-and-space patterns in which periodic directions are different from each other, are mixed), as disclosed in Japanese Patent Application Laid-open No. 6-53120 as well, by using the combination of a zonal illumination method and the polarized illumination method in which the linear polarization is effected in the tangential direction of the circle having the center of the optical axis, the high image formation performance can be obtained even when the numerical aperture NA of the projection optical system is large. For example, in the case that the halftone type phase shift mask having a transmittance of 6% (pattern with a half pitch of about 63 nm) is illuminated by using the combination of the polarized illumination method in which linear polarization is effected in the tangential direction of the circle having the center of the optical axis and the zonal illumination method (a zonal ratio is 3/4), when the illumination σ is 0.95 and the numerical aperture of the projection optical system PL is NA=1.00, the depth of focus (DOF) can be increased by 250 nm more than that of the case which a random polarized beam is used, and when the pattern has a half pitch of about 55 nm and the numerical aperture of the projection optical system is NA=1.2, the depth of focus can be increased by about 100nm.

Furthermore, in addition to the above-described various illumination methods, for example, application of the progressive focal exposure method as disclosed in Japanese Patent Application Laid-open No. 4-277612 or 2001-345245 or the multiwavelength exposure method which is used an exposure light beam with multi-wavelengths (for example, two wavelengths) and obtains the same effect as that of the progressive focal exposure method, is also effective.

When the pressure, which is generated by the flow of the liquid LQ between the first optical element LS1 disposed at the end portion of the projection optical system PL and the substrate P, is large, instead of allowing the first optical element LS1 to be exchangeable, the first optical element LS1 may be tightly fixed so as not to move by the pressure.

Those applicable as the substrate P of the respective embodiments described above, include, for example, a glass substrate for a display device, a ceramic wafer for a thin-film magnetic head, and a master plate (synthetic silica glass, silicon wafer) of the mask or the reticle to be used for the exposure apparatus as well as the semiconductor wafer for producing the semiconductor device.

As for the exposure apparatus EX, the present invention is also applicable to the scanning type exposure apparatus (scanning stepper) based on the step-and-scan system for performing the scanning exposure with the pattern of the mask M by synchronously moving the mask M and the substrate P as well as the projection exposure apparatus (stepper) based on the step-and-repeat system for performing the full field exposure with the pattern of the mask M in a state in which the mask M and the substrate P are allowed to stand still, while successively step-moving the substrate P.

As for the exposure apparatus EX, the present invention is also applicable to the exposure apparatus of such a system that the substrate P is subjected to the full field exposure with a reduction image of a first pattern in a state in which the first pattern and the substrate P are allowed to substantially stand still by using a projection optical system (for example, a dioptric type projection optical system that has a reduction magnification of 1/8 and includes no catoptric element). In the case, the present invention is also applicable to the full field exposure apparatus based on the stitch system in which the substrate P is thereafter subjected to the full field exposure with a reduction image of a second pattern while partially overlaying it on the first pattern by using the projection optical system in a state in which the second pattern and the substrate P substantially stand still. As for the exposure apparatus based on the stitch system, the present invention is also applicable to the exposure apparatus based on the step-and-stitch system in which at least two patterns are partially overlaid and transferred on the substrate P, and the substrate P is successively moved. The above-described embodiments exemplify the exposure apparatus including a projection optical system PL. However, the present invention is also applicable to an exposure apparatus and an exposure method which do not use the projection optical system PL.

The present invention is also applicable to a twin-stage type exposure apparatus. The structure and the exposure operation of the twin-stage type exposure apparatus are disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), or United States Patent No. 6,208,407, contents of which are incorporated herein by reference within a range of permission of the domestic laws and ordinances of the state designated or selected in this international application.

The embodiments described above adopt the exposure apparatus in which the liquid is locally filled the space between the projection optical system PL and the substrate P. However, the present invention is also applicable to a liquid immersion exposure apparatus in which the substrate is exposed in a state that the entire surface of the substrate has been immersed in the liquid as disclosed in Japanese Patent Application Laid-open Nos. 6-124873, 10-303114, and United States Patent No. 5,825,043, etc. The structure and the exposure operation of this liquid immersion exposure apparatus are described in detail in United States Patent No. 5,825,043, contents of which are incorporated herein by reference within a range of permission of the domestic laws and ordinances of the state designated or selected in this international application.

As for the type of the exposure apparatus EX, the present invention is not limited to the exposure apparatus for the semiconductor device production for exposing the substrate P with the semiconductor device pattern. The present invention is also widely applicable, for example, to the exposure apparatus for producing the liquid crystal display device or for producing the display as well as the exposure apparatus for producing, for example, the thin film magnetic head, the image pickup device (CCD), the reticle, or the mask.

When the linear motor (see US Patent No. 5,623,853 or 5,528,118) is used for the substrate stage PST and/or the mask stage MST, it is allowable to use any one of those of the air floating type based on the use of the air bearing and those of the magnetic floating type based on the use of the Lorentz's force or the reactance force. Each of the stages PST, MST may be either of the type in which the movement is effected along the guide or of the guideless type in which no guide is provided. An example of the use of the linear motor for the stage is disclosed in United States Patent Nos. 5,623,853 and 5,528,118, contents of which are incorporated herein by reference respectively within a range of permission of the domestic laws and ordinances of the state designated or selected in this international application.

As for the driving mechanism for each of the stages PST, MST, it is also allowable to use a plane motor in which a magnet unit provided with two-dimensionally arranged magnets and an armature unit provided with two-dimensionally arranged coils are opposed to one another, and each of the stages PST, MST is driven by the electromagnetic force. In this case, any one of the magnet unit and the armature unit is connected to the stage PST, MST, and the other of the magnet unit and the armature unit is provided on the side of the movable surface of the stage PST, MST.

The reaction force, which is generated in accordance with the movement of the substrate stage PST, may be mechanically released to the floor (ground) by using a frame member so that the reaction force is not transmitted to the projection optical system PL, as described in Japanese Patent Application Laid-open No. 8-166475 (United States Patent No. 5,528,118), and contents of United States Patent No. 5,528,118 are incorporated herein by reference within a range of permission of the domestic laws and ordinances of the state designated or selected in this international application.

The reaction force, which is generated in accordance with the movement of the mask stage MST, may be mechanically released to the floor (ground) by using a frame member so that the reaction force is not transmitted to the projection optical system PL, as described in Japanese Patent Application Laid-open No. 8-330224 (United States Patent No. 5,874,820), and contents of United States Patent No. 5,874,820 are incorporated herein by reference within a range of permission of the domestic laws and ordinances of the state designated or selected in this international application.

As described above, the exposure apparatus EX according to the embodiment of the present invention is produced by assembling the various subsystems including the respective constitutive elements as defined in claims of this application so that the predetermined mechanical accuracy, the electric accuracy, and the optical accuracy are maintained. In order to secure the various accuracies, adjustments performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

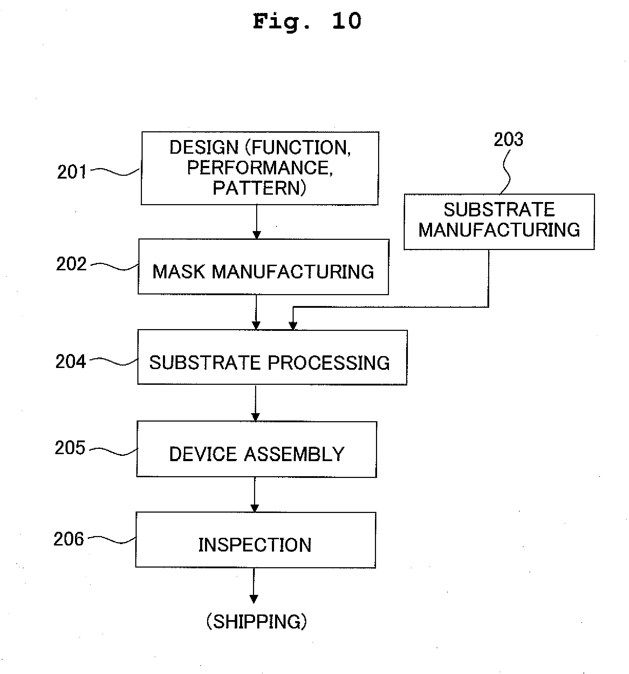

As shown in Fig. 10, the microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, a substrate processing (exposure process) step 204 of exposing the substrate with a pattern of the mask by using the exposure apparatus EX of the embodiment described above and developing the exposed substrate, a step 205 of assembling the device (including a dicing step, a bonding step, and a packaging step), and an inspection step 206, etc. The substrate processing step 204 includes measurements of the liquid and adjustments of the liquid ratio, as described in Fig. 5.

### INDUSTRIAL APPLICABILITY

According to the invention, desired image formation characteristic can be maintained by measuring and adjusting the optical property of the liquid to be used for the liquid immersion exposure, so that a device having a device pattern with higher resolution and higher density can be produced.

## Claims

1. An exposure apparatus which exposes a substrate through a liquid, comprising:
a projection optical system; and
a measuring device which measures optical property of the liquid.

2. The exposure apparatus according to Claim 1, wherein the optical property includes at least one of a refractive index and a light transmittance of the liquid.

3. The exposure apparatus according to Claim 1, further comprising a liquid supply mechanism which supplies the liquid to a side of an image plane of the optical system,
wherein the measuring device optically measures the optical property of a liquid supplied by the liquid supply mechanism.

4. The exposure apparatus according to Claim 1, wherein the liquid supply mechanism has a supply passage in which the liquid flows, and the measuring device optically measures optical the property of the liquid flowing in the supply passage.

5. The exposure apparatus according to Claim 1, further comprising an adjusting mechanism which performs an adjustment of an exposure condition based on the result of measurement by the measuring device.

6. The exposure apparatus according to Claim 5, wherein the adjustment includes an adjustment of the optical property of the liquid.

7. The exposure apparatus according to Claim 6, wherein the adjustment of the optical property of the liquid includes a mixing of a predetermined substance with the liquid.

8. The exposure apparatus according to Claim 6, comprising a mixing device which mixes a plurality of liquids,
wherein the liquid prepared by the mixing device fills an optical path space, and the adjustment of the optical property of the liquid includes an adjustment of a mixing ratio of the plurality of liquids.

9. The exposure apparatus according to Claim 8,
wherein the plurality of liquids have mutually different optical property.

10. The exposure apparatus according to Claim 8, further comprising a storage device which stores in advance a relationship between the mixing ratio and the optical property of the liquid mixed at the mixing ratio,
wherein the mixing device performs mixing based on information stored in the storage device.

11. The exposure apparatus according to Claim 5, wherein the adjustment includes an adjustment of the positional relationship between a surface of the substrate and a position of an image plane formed via the projection optical system and the liquid.

12. The exposure apparatus according to Claim 11, further comprising a storage device which stores in advance a relationship between the optical property of the liquid and the position of the image plane formed via the projection optical system and the liquid,
wherein the adjusting mechanism performs adjustment based on information stored in the storage device.

13. The exposure apparatus according to Claim 11, further comprising a substrate stage which is movable while holding the substrate,
wherein the adjusting mechanism includes a stage adjusting device which adjusts a position of the substrate stage.

14. The exposure apparatus according to Claim 5,
wherein the adjusting mechanism includes an image formation characteristic adjusting device which adjusts an image formation characteristic.

15. The exposure apparatus according to Claim 5, wherein the adjustment includes a temperature adjustment of the liquid.

16. The exposure apparatus according to Claim 5, wherein the measuring device includes a first measuring instrument which measures the liquid and a second measuring instrument which measures the liquid which has been adjusted based on a result of measurement by the first measuring instrument.

17. The exposure apparatus according to Claim 16, wherein the optical property of the liquid is adjusted based on the result of measurement by the first measuring instrument, and
a positional relationship between a position of an image plane of the projection optical system and a surface of the substrate is adjusted based on a result of measurement by the second measuring instrument.

18. The exposure apparatus according to Claim 3, further comprising a liquid recovery mechanism which recovers the liquid on the side of the image plane of the projection optical system and returns at least a part of the liquid which has been recovered to the liquid supply mechanism for reuse.

19. The exposure apparatus according to Claim 1, further comprising a reporting device which reports a result of measurement by the measuring device.

20. The exposure apparatus according to any one of Claims 1 to 19, wherein a refractive index of the liquid with respect to an exposure light beam is greater than that of a first optical element disposed closest to an image plane of the projection optical system, the first optical element being included in a plurality of optical elements of the projection optical system.

21. The exposure apparatus according to Claim 1, an optical path on a side of an image plane of the projection optical system is filled with the liquid, and the substrate is exposed via the projection optical system and the liquid.

22. The exposure apparatus according to Claim 16, further comprising a temperature controller which adjusts a temperature of the liquid which has been adjusted based on the result of measurement by the first measuring instrument.

23. An exposure apparatus which exposes a substrate through a liquid, comprising:
a projection optical system;
a liquid supply mechanism which supplies the liquid to a side of an image plane of the projection optical system; and
a mixing device which is provided in the liquid supply mechanism and mixes a plurality of liquids,
wherein the liquid supply mechanism supplies the liquid mixed by the mixing device.

24. The exposure apparatus according to Claim 23, wherein the mixing device mixes the plurality of liquids which have mutually different optical property.

25. The exposure apparatus according to Claim 23, comprising a measuring device which measures the liquid mixed by the mixing device.

26. The exposure apparatus according to Claim 25, wherein the measuring device measures optical property of the liquid.

27. The exposure apparatus according to Claim 24, wherein the optical property includes at least one of an refractive index and a light transmittance of the liquid.

28. The exposure apparatus according to Claim 23, wherein the mixing device mixes a liquid which is supplied to the side of the image plane of the projection optical system according to optical characteristics of a first optical element disposed closest to the image plane of the projection optical system, the first optical element being included in a plurality of optical elements of the projection optical system.

29. The exposure apparatus according to Claim 28, wherein the mixing device mixes the liquid so that the liquid has a refractive index greater than that of the first optical element.

30. The exposure apparatus according to Claim 28, wherein the mixing device mixes the liquid so that the liquid has a refractive index substantially equal to that of the first optical element.

31. The exposure apparatus according to any one of Claims 23 to 30, comprising a liquid recovery mechanism which recovers the liquid supplied by the liquid supply mechanism,
wherein the liquid recovery mechanism returns the liquid which has been recovered to the liquid supply mechanism.

32. The exposure apparatus according to Claim 31, wherein the liquid recovery mechanism returns a part of the liquid which has been recovered.

33. The exposure apparatus according to Claim 31, wherein the liquid recovery mechanism includes a process device which performs a predetermined process for the liquid which has been recovered, and returns the liquid which has been treated by the treatment device to the liquid supply mechanism.

34. The exposure apparatus according to Claim 33, wherein the treatment device cleans the liquid which has been recovered.

35. The exposure apparatus according to Claim 31, wherein the liquid supply mechanism again supplies the liquid returned from the liquid recovery mechanism to the side of the image plane of the projection optical system.

36. The exposure apparatus according to Claim 1, wherein an optical path on a side of an image plane of the projection optical system is filled with the liquid, and the substrate is exposed via the projection optical system and the liquid.

37. The exposure apparatus according to Claim 25, further comprising a controller which adjusts a mixing ratio of the plurality of liquids in the mixing device according to a result of measurement by the measuring device.

38. A method for producing a device using the exposure apparatus as defined in Claim 1 or Claim 23.

39. An exposure method for exposing a substrate with an image of a predetermined pattern through a liquid, comprising:
measuring optical property of the liquid before supplying the liquid to an area in which the image of the predetermined pattern is formed;
adjusting exposure conditions; and
exposing the substrate with the image of the predetermined pattern through the liquid.

40. The exposure method according to Claim 39, wherein the optical property includes at least one of a refractive index and a light transmittance of the liquid.

41. The exposure method according to Claim 39, wherein the exposure conditions include at least one of image formation characteristic of the image of the predetermined pattern and the optical property of the liquid.

42. The exposure method according to any one of Claims 39 to 41, comprising re-supplying the liquid to the area in which the image of the predetermined pattern is formed, after supplying the liquid to the area and recovering the liquid from the area; and measuring the optical property of the liquid after being recovered and before being re-supplied.

43. The exposure method according to Claim 42, further comprising adjusting a component or a temperature of the liquid after being recovered and before being re-supplied.

44. The exposure method according to Claim 43, further comprising measuring the optical property of the liquid after adjusting the component or the temperature of the liquid.

45. An exposure method for exposing a substrate with an image of a predetermined pattern through a liquid, comprising:
mixing a plurality of liquids;
measuring optical property of the liquid before or after the mixing of the plurality of liquids; and
exposing the substrate through the liquid which has been mixed.

46. The exposure method according to Claim 45, further comprising adjusting a mixing ratio of the plurality of liquids based on a result of optical measurement of the liquid before the mixing.

47. The exposure method according to Claim 45, further comprising adjusting an image formation characteristic of the predetermined pattern based on a result of optical measurement of the liquid after the mixing.

48. The exposure method according to Claim 45, comprising adjusting a temperature of the liquid which has been mixed.

49. The exposure method according to Claim 45, wherein the image of the predetermined pattern is projected onto the substrate by an optical element, the liquid is supplied in a space between the substrate and the optical element, and a refractive index of the liquid is not less than a refractive index of the optical element.

50. The exposure method according to any one of Claims 45 to 49, comprising re-supplying the liquid which has been mixed to an area in which the image of the predetermined pattern is formed, after supplying the liquid to the area and recovering the liquid from the area; measuring the optical property of the liquid after being recovered and before being re-supplied; and adjusting a mixing ratio of the plurality of liquids based on a result of measurement of the optical property of the liquid after being recovered and before being re-supplied.

51. An exposure method for exposing a substrate with an image of a predetermined pattern through a liquid, comprising:
mixing a plurality of liquids;
adjusting an image formation characteristic of the image of the predetermined pattern so that a desired image of the predetermined pattern is obtained; and
exposing the substrate through the liquid has been mixed.

52. A method for producing a device comprising:
exposing a substrate by the exposure method as defined in any one of Claims 39, 45, and 51;
developing the substrate which has been exposed; and
processing the substrate which has been developed.
